# EUROPÄISCHE PATENTANMELDUNG

(11) **EP 2 469 601 A2**
(43) Veröffentlichungstag der Anmeldung: **27.06.2012**
(21) Anmeldenummer: 11009807.6
(22) Anmeldetag: 14.12.2011
(51) Int. Cl.: H01L 31/02, H01L 31/042

(54) **Solarmodul und Verfahren**

(30) Priorität: 22.12.2010 DE 102010055486
(71) Anmelder: Diehl AKO Stiftung & Co. KG, 88239 Wangen (DE)
(72) Erfinder: Schill, Christoph, 88213 Ravensburg (DE)
(74) Vertreter: Diehl Patentabteilung

(57) **Zusammenfassung**

Ein Solarmodul umfasst einen Solargenerator (10) zum Umwandeln einfallender Strahlung in elektrische Leistung; einen mit dem Solargenerator (10) verbundenen Zwischenkreis; einen Solarwechselrichter (12) zum Einspeisen der vom Solargenerator (10) erzeugten Leistung in ein Netz (14) oder einen Verbraucher; eine variable Vorlast (18), die an den Solargenerator (10) angeschlossen ist; und eine Steuervorrichtung (20) zum Ansteuern der variablen Vorlast (18). Ferner ist mit dem Solargenerator (10) wenigstens ein DC/DC-Wandler (22; 22₁, 22₂; 22₃) zur Energieversorgung des Solarwechselrichters (12) von der Solargeneratorseite verbunden und ist die variable Vorlast (18) an den wenigstens einen DC/DC-Wandler (22; 22₁, 22₂; 22₃) angeschlossen.

## Beschreibung

Die vorliegende Erfindung betrifft ein Solarmodul, insbesondere ein Solarmodul nach dem Oberbegriff des Anspruches 1, sowie ein Verfahren hierfür.

Aus der EP 1 970 964 A2 ist ein Solarmodul bekannt, wie es beispielhaft in Figur 5 dargestellt ist. Dieses Solarmodul umfasst einen Solargenerator 10 zum Umwandeln einfallender Strahlung in elektrische Leistung, einen dem Solargenerator 10 parallel geschalteten Zwischenkreiskondensator 16 und einen Solarwechselrichter 12 zum Einspeisen der vom Solargenerator 10 erzeugten Leistung in ein Netz 14 oder einen Verbraucher. Um eine Netzeinspeisung durch den Solarwechselrichter 12 nur bei ausreichender Leistung des Solargenerators 10 zu erlauben, ist zudem eine variable Vorlast 18 vorgesehen, die an den Solargenerator 10 angeschlossen ist und von einer in den Solarwechselrichter 12 integrierten Steuervorrichtung 20 angesteuert wird. Diese Steuervorrichtung 20 ist dabei derart ausgebildet, dass sie die aktuell verfügbare Leistung des Solargenerators 10 sowie einen aktuellen Leerlaufverlust des Solarwechselrichters 12 erfassen kann und die erfasste Leistung des Solargenerators 10 und den erfassten Leerlaufverlust des Solarwechselrichters 12 vergleichen kann, um schließlich ein Einspeisen der Leistung des Solargenerators 10 durch den Solarwechselrichter 12 in das Netz 14 oder den Verbraucher nur dann freizuschalten, wenn die erfasste Leistung des Solargenerators 10 den erfassten Leerlaufverlust des Solarwechselrichters 12 übersteigt, d.h. wenn die Solargeneratorleistung die Leerlaufverluste des Solarwechselrichters 12 kompensiert.

Es ist eine Aufgabe der vorliegenden Erfindung, ein verbessertes Solarmodul mit einer einfacheren variablen Vorlast zu schaffen, sowie ein Verfahren zu dessen Betrieb bereitzustellen.

Die erstgenannte Aufgabe wird gelöst durch ein Solarmodul mit den Merkmalen des Anspruches 1. Vorteilhafte Ausgestaltungen und Weiterbildungen der Erfindung sind Gegenstand der abhängigen Ansprüche.

Das Solarmodul umfasst einen Solargenerator zum Umwandeln einfallender Strahlung in elektrische Leistung; einen mit dem Solargenerator verbundenen Zwischenkreis; einen Solarwechselrichter zum Einspeisen der vom Solargenerator erzeugten Leistung in ein Netz oder einen Verbraucher; eine variable Vorlast, die an den Solargenerator angeschlossen ist; und eine Steuervorrichtung zum Ansteuern der variablen Vorlast. Das Solarmodul ist erfindungsgemäß dadurch gekennzeichnet, dass der Solargenerator mit wenigstens einem DC/DC-Wandler zur Energieversorgung des Solarwechselrichters verbunden ist und die variable Vorlast an den wenigstens einen DC/DC-Wandler angeschlossen ist.

Der Solargenerator ist mit wenigstens einem DC/DC-Wandler zur internen Energieversorgung des Solarwechselrichters verbunden. Dies bedeutet, dass der Solarwechselrichter bzw. die integrierte Steuerelektronik nicht mehr durch das Wechselstromnetz betrieben werden muss, sondern von der Solargeneratorseite und damit unabhängig von der Netzspannung versorgt werden kann. Dies gewährleistet einen störungsfreien Betrieb des Solarmoduls auch bei einer Netzunterbrechung.

Die variable Vorlast, welche dem Erfassen der aktuellen Leistungsfähigkeit des Solargenerators dient, ist bei dem erfindungsgemäßen Solarmodul an diesen wenigstens einen DC/DC-Wandler angeschlossen. Dies hat den Vorteil, dass die variable Vorlast nicht an der variablen Spannung des Solargenerators, sondern an der konstanten Ausgangsspannung des DC/DC-Wandlers arbeitet, wodurch der Aufbau der variablen Vorlast stark vereinfacht werden kann. Da der DC/DC-Wandler an seinem Ausgang zudem eine konstante Kleinspannung bereitstellt, kann der Isolationsaufwand der variablen Vorlast reduziert werden und können für den Aufbau der variablen Vorlast kostengünstigere Bauteile verwendet werden.

Des Weiteren kann die Leistungskapazität der variablen Vorlast um die Verluste im DC/DC-Wandler reduziert werden, wodurch der Aufbau der variablen Vorlast einfacher bzw. kostengünstiger gestaltet werden kann.

Zur Einhaltung neuer Normvorschriften besteht ohnehin Bedarf, die interne Stromversorgung des Solarmoduls vom Betrieb am AC-Netz auf einen Betrieb am Solargenerator umzustellen. Dies kann durch die Integration eines DC/DC-Wandlers erreicht werden, der die vom Solargenerator erzeugte Spannung auf eine konstante Kleinspannung umsetzt. Mit einem solchen DC/DC-Wandler besteht nun zugleich die Möglichkeit, eine einfachere und kostengünstigere variable Vorlast in dem Solarmodul zu realisieren.

Die zweitgenannte Aufgabe wird gelöst durch ein Verfahren zur Reduzierung der Leistungskapazität einer Vorlast eines Solarmoduls wobei eine die Vorlast unterstützende Belastung erzeugt wird. Vorteilhafte Ausgestaltungen und Weiterbildungen der Erfindung sind Gegenstand der abhängigen Ansprüche.

In vorteilhafter Weise kann der Solargenerator aus mehreren Teilgeneratoren aufgebaut sein. Der Solargenerator kann direkt oder über einen oder mehrere DC/DC-Wandler mit dem Zwischenkreis verbunden sein. Abhängig von der Schaltungstopologie des Solarmoduls kann der Zwischenkreis mehrere Teilzwischenkreise aufweisen.

In einer vorteilhaften Weiterbildung weist der Zwischenkreis zur Energiespeicherung wenigstens einen Zwischenkreiskondensator oder wenigstens eine Drossel auf.

In einer bevorzugten Ausgestaltung ist die variable Vorlast eine lineare oder getaktete Stromsenke, die bevorzugt einen ein- und ausschaltbaren Widerstand aufweist, und/oder wenigstens ein schaltbarer Verbraucher, bevorzugt mit variabel einstellbarer Stromaufnahme, und/oder wenigstens ein steuerbarer Verbraucher.

Die variable Vorlast ist eine Stromsenke, die einen Widerstand aufweist, der ein-und ausschaltbar ist, wobei das Schaltmittel hierfür bevorzugt ein Transistor ist. Die Belastung der variablen Vorlast ist analog einstellbar, also linear, oder über ein Ein-Aus-Verhältnis, also getaktet.

Alternativ oder zusätzlich dazu ist an den wenigstens einen DC/DC-Wandler wenigstens ein schaltbarer Verbraucher angeschlossen. Derartige schaltbare Verbraucher, die in einem Solarmodul üblicherweise ohnehin vorhanden sind, können die variable Vorlast weiter entlasten, weshalb die Leistungskapazität der variablen Vorlast reduziert werden kann. Zu dieser Art von Verbrauchern können z.B. schaltbare Relais und aus Stromspargründen abschaltbare Sensoren und Steuerschaltkreise gehören.

Alternativ oder zusätzlich dazu ist an den wenigstens einen DC/DC-Wandler wenigstens ein in seiner Stromaufnahme steuerbarer Verbraucher angeschlossen. Derartige Verbraucher, die in einem Solarmodul oft ohnehin vorhanden sind, können die variable Vorlast weiter entlasten und bieten, im Gegensatz zu den schaltbaren Verbrauchern den Vorteil, einer in mehreren Stufen oder stufenlos steuerbaren Stromaufnahme. Zu dieser Art von Verbrauchern können z.B. über Pulsweitenmodulation ansteuerbare Relais, Hinterleuchtungen oder drehzahlvariable Lüfter gehören.

Es ist auch denkbar die Funktion der variablen Vorlast allein durch die im Solarmodul vorhandenen zuschaltbaren und/oder steuerbaren Verbraucher zu realisieren. Durch schrittweises Zuschalten der schaltbaren Verbraucher bzw. unterschiedliche Ansteuerung der steuerbaren Verbraucher kann die Belastung variabel gestaltet werden.

Stromsenke, schaltbarer Verbraucher und steuerbarer Verbraucher können einzeln oder in einer beliebigen Kombination miteinander, als Teilelement der variablen Vorlast, die variable Vorlast bilden. In besonders vorteilhafter Weise sind Teilelemente zueinander parallel geschaltet.

In einer weiteren Ausgestaltung der Erfindung ist der wenigstens eine DC/DC-Wandler ein bis hinab zu sehr kleinen Eingangsspannungen arbeitender DC/DC-Wandler. Auf diese Weise kann der Zwischenkreis bis auf eine niedrige und damit ungefährliche Restladung entladen werden. Dabei ist es ausreichend, wenn der DC/DC-Wandler bei kleinen Eingangsspannungen nur einen Teil seiner Nennleistung liefern kann. Damit die Ausgangsspannung des DC/DC-Wandlers dann nicht zusammenbricht, kann die variable Vorlast in ihrer Leistung zurückgefahren oder bei Unterschreitung einer Mindestspannung ausgeschaltet werden.

In einer weiteren Ausgestaltung der Erfindung weist der wenigstens eine DC/DC-Wandler mehrere Ausgänge zum verteilten Anschließen von Teilelementen der Vorlast auf. Die als Vorlast wirkenden Teilelemente können alle auf einen Ausgang konzentriert oder auf die verschiedenen Ausgänge verteilt sein.

Ferner kann eine Anzeigevorrichtung zum Anzeigen eines Ladungszustandes des Zwischenkreises bzw. eines Zwischenkreiskondensators vorgesehen sein. Dies kann zum Beispiel der Warnung von Personal dienen.

Ebenso kann eine Anzeigevorrichtung zum Anzeigen eines Entladestroms des Zwischenkreises bzw. eines Zwischenkreiskondensators durch die variable Vorlast vorgesehen sein.

In einer noch weiteren Ausgestaltung der Erfindung enthält der Zwischenkreis mehrere Zwischenkreiskondensatoren und der wenigstens eine DC/DC-Wandler umfasst wenigstens einen DC/DC-Wandler mit einem Mehrfach-Eingang, wobei dieser Mehrfach-Eingang mit mehreren Zwischenkreiskondensatoren gekoppelt ist. Alternativ oder zusätzlich kann der wenigstens eine DC/DC-Wandler mehrere DC/DC-Wandler umfassen, von denen wenigstens ein DC/DC-Wandler ein DC/DC-Wandler mit einem Einfach-Eingang ist, wobei dieser Einfach-Eingang mit einem der mehreren Zwischenkreiskondensatoren gekoppelt ist.

Bei dieser Konfiguration kann eine Symmetrierung oder Ladungsbalancierung der Zwischenkreiskondensatoren des Zwischenkreises erfolgen. Dabei arbeiten alle DC/DC-Wandler vorzugsweise auf einen bzw. mehrere gemeinsame Ausgänge, an welchen die variable Vorlast angeschlossen ist. Der/die DC/DC-Wandler wird bzw. werden dann beispielsweise so geregelt, dass der höher aufgeladene Zwischenkreiskondensator stärker entladen wird, um die Symmetrierung zu bewirken.

In einer bevorzugten Alternative ist der Solargenerator mit dem wenigstens einen Zwischenkreis über wenigstens einen weiteren DC/DC-Wandler verbunden.

In einer noch weiteren Ausgestaltung der Erfindung ist die Steuervorrichtung ein Mikrocontroller. In vorteilhafter Weise ist die Steuervorrichtung im Wechselrichter integriert.

In einer vorteilhaften Weiterbildung des Verfahrens wird die unterstützende Belastung durch wenigstens einen Verbraucher erzeugt, der üblicher Weise in einem Solarmodul enthalten ist.

In einer bevorzugten Alternative wird die variable Vorlast durch eine leerlaufende Leistungselektronik eines Solarwechselrichters unterstützt.

Dies wird vorteilhaft erreicht, indem die noch nicht mit dem Netz verbundene Leistungselektronik des Solarwechselrichters im Leerlauf betrieben wird. Hierzu kann am Ausgang des Solarwechselrichters eine Gleichspannung oder eine Wechselspannung erzeugt werden. Die erzeugte Wechselspannung kann so gewählt werden, dass ihre Amplitude und Phase synchron mit der der Netzspannung läuft, wodurch sich bei Zuschaltung aufs Netz der Einschaltstromstoß reduziert.

In einer weiteren Ausführungsform wird die unterstützende Belastung durch eine Variation der Taktfrequenz der Leistungshalbleiter der leerlaufenden Leistungselektronik variiert.

Zweckmäßiger Weise wird die unterstützende Belastung durch eine Variation der Taktfrequenz der Leistungshalbleiter der leerlaufenden Leistungselektronik und/oder durch eine Variation der Ausgangsfrequenz des Solarwechselrichters und/oder durch eine Variation der Ausgangsspannung des Solarwechselrichters variiert.

Die Leistungselektronik kann beim Leerlaufbetrieb mit variabler Taktfrequenz angesteuert werden, so dass die Verluste in Halbleitern und Drosseln und damit auch die Belastung variabel ist. Die Belastung ist auch veränderbar, indem die Leerlauf-Ausgangswechselspannung des Wechselrichters in Frequenz oder Amplitude variiert wird. Je höher die Frequenz und je höher die Amplitude, desto größer sind die Blindströme und damit die Verluste, welche in Halbleitern und in nachfolgenden Filtern entstehen.

In einer besonders vorteilhaften Weiterbildung wird der Solargenerator weniger stark belastet, als es den Leerlaufverlusten des Solarwechselrichters entspricht.

Das Verringern der benötigten Leistungskapazität der Vorlast erfolgt dadurch, dass der Solargenerator weniger stark belastet wird, als es den Leerlaufverlusten des Solarwechselrichters im Einspeisebetrieb entspricht. Beim Aufschalten dieser verringerten Vorlast bricht die Spannung am Solargenerator ein, woraus die verfügbare Leistung des Solargenerators hochgerechnet werden kann. Dieses Verfahren wird in der DE 10 2008 059 428 A1, auf die vollumfänglich Bezug genommen wird, beschrieben.

Die Erfindung ist nicht auf den Betrieb mit einem Solargenerator beschränkt. Anstelle des Solargenerators können auch andere Energiequellen verwendet werden. Beispielsweise sind thermoelektrische Generatoren, Brennstoffzellen und dergleichen ebenfalls als speisende Gleichstromquellen denkbar.

Obige sowie weitere Merkmale, Vorteile und Anwendungsmöglichkeiten der Erfindung werden aus der nachfolgenden Beschreibung bevorzugter, nichteinschränkender Ausführungsbeispiele unter Bezugnahme auf die beiliegenden Zeichnungen besser verständlich. Darin zeigen:
- Fig. 1: ein vereinfachtes Blockschaltbild eines Solarmoduls gemäß einem ersten Ausführungsbeispiel der vorliegenden Erfindung;
- Fig. 2: ein vereinfachtes Blockschaltbild eines Solarmoduls gemäß einem zweiten Ausführungsbeispiel der vorliegenden Erfindung;
- Fig. 3: ein vereinfachtes Blockschaltbild eines Solarmoduls gemäß einem dritten Ausführungsbeispiel der vorliegenden Erfindung
- Fig. 4: ein vereinfachtes Blockschaltbild eines Solarmoduls gemäß einem vierten Ausführungsbeispiel der vorliegenden Erfindung; und
- Fig. 5: ein vereinfachtes Blockschaltbild eines herkömmlichen Solarmoduls.

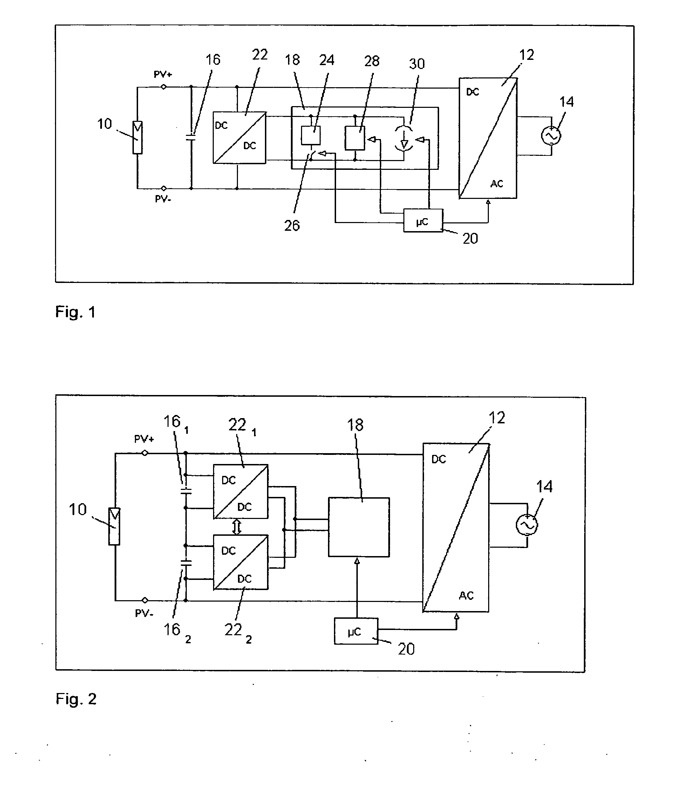

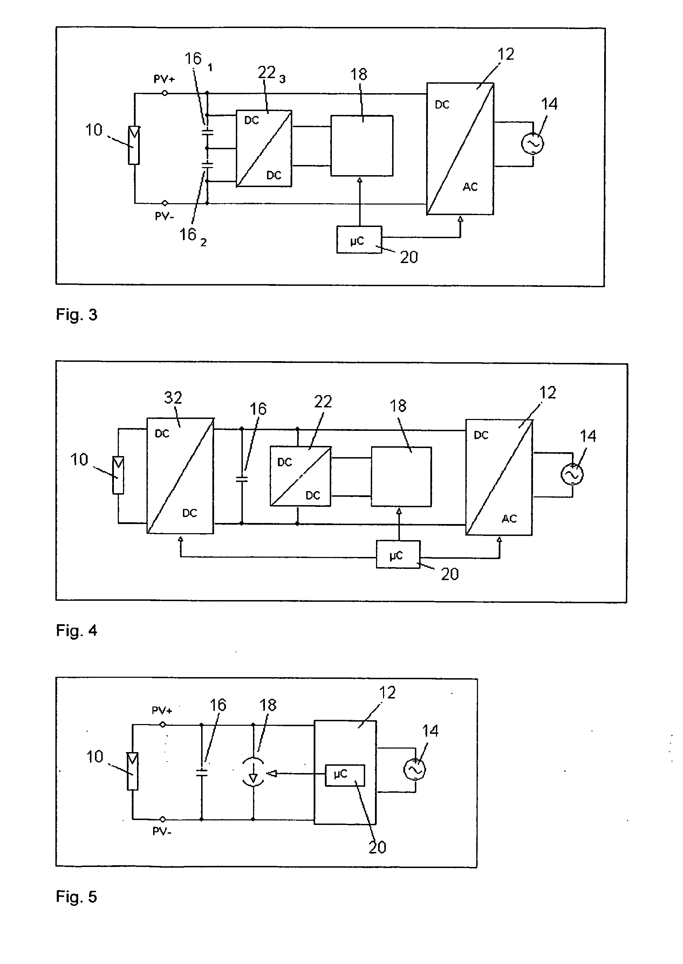

In Fig. 1 ist in vereinfachter Form eine Grundschaltung des erfindungsgemäßen Solarmoduls als erstes Ausführungsbeispiel dargestellt. Dabei sind gleiche bzw. entsprechende Komponenten mit den gleichen Bezugsziffern wie bei der in Fig. 5 gezeigten herkömmlichen Schaltungsanordnung gekennzeichnet.

Das Solarmodul von Fig. 1 enthält einen Solargenerator 10 zum Umwandeln einfallenden Lichts in elektrische Leistung und einen Solarwechselrichter 12 zum Einspeisen der vom Solargenerator 10 erzeugten Leistung in ein Netz 14 oder einen Verbraucher. Wie in Fig. 1 dargestellt, ist der Solargenerator 10 mit einem Zwischenkreis mit einem Zwischenkreiskondensator 16 verbunden.

Des Weiteren ist der Solargenerator 10 und der Zwischenkreis 16 mit einem DC/DC-Wandler 22 verbunden. Dieser DC/DC-Wandler 22 setzt die vom Solargenerator 10 erzeugte und vom Zwischenkreis 16 geglättete, variable Spannung in eine im Wesentlichen konstante Kleinspannung um. Mit dieser konstanten Kleinspannung kann dann die Steuerelektronik des Solarmoduls von der Solargeneratorseite versorgt werden. D.h. die Steuerelektronik des Solarmoduls muss nicht vom Netz 14 versorgt werden und das Solarmodul kann somit auch bei sehr geringer oder fehlender Netzspannung Strom in das Netz 14 einspeisen.

Weiter ist das Solarmodul mit einer variablen Vorlast 18 versehen, die an den Ausgang des DC/DC-Wandlers 22 angeschlossen ist und durch den Mikrocontroller 20 angesteuert wird. Beispielhaft ist die gezeigte Vorlast 18 aus einer Kombination von Teilelementen dargestellt, mit einer Stromsenke 30, einem Schaltbaren 26 Verbraucher und einem steuerbaren Verbraucher 28. Die Vorlast 18 kann aber auch durch eine andere Kombination der Teilelemente oder auch durch ein einzelnes Teilelement gebildet sein, beispielsweise durch eine Stromsenke 30 in Form eines mittels Transistor ein- und ausschaltbaren Widerstands.

Aufgrund des Anschlusses der variablen Vorlast 18 an den DC/DC-Wandler 22 muss sich diese nicht an die variable Spannung des Solargenerators 10 anpassen. Stattdessen formt der DC/DC-Wandler 22 diese variable Spannung des Solargenerators 10 in eine konstante Kleinspannung um, für welche eine konstante Leistungsaufnahme durch die variable Vorlast 18 viel leichter zu erreichen ist.

Ferner verringert sich durch die durch den DC/DC-Wandler 22 bereitgestellte Kleinspannung der Isolationsaufwand für die variable Vorlast 18 und es sind kostengünstigere Bauteile einsetzbar. Außerdem kann die variable Vorlast 18 in ihrer Leistungskapazität um die im DC/DC-Wandler 22 entstehenden Verluste reduziert werden. Aus den genannten Punkten ergeben sich erhebliche Einsparungen an Platzbedarf und Kostenaufwand für die variable Vorlast 18.

Wie in Fig. 1 dargestellt, können vorhandene Verbraucher 24 und 28 des Solarmoduls, die ebenfalls aus dem DC/DC-Wandler 22 gespeist werden und wahlweise zu- und abschaltbar oder in ihrer Stromaufnahme steuerbar sind, parallel zur Stromsenke 30 als Zusatzlasten verwendet werden. Die Stromsenke 30 kann hierdurch dementsprechend in ihrer Leistungsfähigkeit reduziert oder sogar vollständig durch einen schaltbaren Verbraucher 24 bzw. steuerbaren Verbraucher 28 ersetzt werden.

Der Mikrocontroller 20 dient der Ansteuerung der variablen Vorlast 18 bzw. der darin enthaltenen Teilelemente. Die Ansteuerung des Wechselrichters 12 und dessen Leerlauf-Betrieb als Zusatzbelastung für den Solargenerator 10 kann über denselben Mikrocontroller 20 erfolgen.

Die Funktionsweise dieses Solarmoduls ist wie folgt.

Vor Zuschaltung des Solarwechselrichters 12 auf das Netz 14 wird der Solargenerator 10 mit Hilfe der variablen Vorlast 18 belastet. Die Belastung wird dabei durch den Mikrocontroller 20 so eingestellt, dass die momentan verfügbare Leistung des Solargenerators 10 in einem optimalen Arbeitspunkt gemessen werden kann. Gleichzeitig berechnet der Mikrocontroller 20 die Leerlaufverluste des Solarwechselrichters 12, die sich momentan bei Netzaufschaltung ergeben würden. Diese Leerlaufverluste sind hauptsächlich von der Netzspannung und der Solargeneratorspannung abhängig, und ihr Verlauf hängt stark von der Topologie des Solarwechselrichters 12 ab.

Überschreitet die gemessene Leistung des Solargenerators 10 die berechneten (oder erfassten) Leerlaufverluste des Solarmoduls, so schaltet der Mikrocontroller 20 den Solarwechselrichter 12 auf das Netz 14 oder den Verbraucher. Da sich der Solargenerator 10 bereits im optimalen Arbeitspunkt befindet, ist ein nahtloser Übergang in den Einspeisebetrieb ohne Energieverluste möglich.

Um auch bei schwankender Generatorleistung eine stabile Funktion des Solarmoduls zu erreichen, können weitere Zuschaltbedingungen für den Solarwechselrichter 12 eingesetzt werden. Zum Beispiel muss die ausreichende Generatorleistung für eine vorgegebene Mindestzeitdauer zur Verfügung stehen.

Der Arbeitspunkt, in dem die Leistung des Solargenerators 10 gemessen wird, kann der MPP (maximum power point) des Solargenerators 10 sein. Bevorzugter wird jedoch in einem Arbeitspunkt gemessen, der für das gesamte Solarmodul den MPP darstellt. Dies ist möglich, ohne dass sich das Solarmodul im Einspeisebetrieb befindet, da dessen Verluste und ihre Abhängigkeit von Netzspannung und Generatorspannung bekannt sind. Der Arbeitspunkt kann wahlweise fest oder in Abhängigkeit von verschiedenen Parametern (z.B. Netzspannung) gewählt werden. Er kann außerdem über Tracking- und Selbstlernfunktionen optimiert werden.

Die Stromsenke 30 des Solarmoduls kann wahlweise linear, d.h. mit analog einstellbarer Belastung, oder getaktet, d.h. mit über das Ein/Aus-Verhältnis einstellbarer Belastung, ausgeführt werden.

Für den Betrieb der variablen Vorlast 18 sind keine zusätzlichen Messeinrichtungen im Solarmodul notwendig, da die Spannungen auf der Generatorseite 10 bzw. am Zwischenkreis 16 und der Netzseite 14 ohnehin gemessen werden müssen. Wenn die gesamte Leistung der Vorlast 18 sowie der Wirkungsgrad des DC/DC-Wandlers 22₁, 22₂, 22₃ und ggf. die Verluste der als Zusatzlast leerlaufenden Leistungselektronik bekannt sind, kann außerdem auf die Messung des Solargeneratorstroms verzichtet werden.

Über die variable Vorlast 18 des Solarmoduls kann bei Bedarf außerdem der Speicherkondensator 16 des Zwischenkreises entladen werden. Der Speicherkondensator 16 ist üblicherweise sehr groß dimensioniert und kann zum Beispiel auf über 800 V geladen werden. Die variable Vorlast 18 kann genutzt werden, um diese Ladung des Speicherkondensators 16 in kurzer Zeit zu beseitigen, was beispielsweise während der Fertigung und im Service von Vorteil ist. Der Speicherkondensator 16 wird hierzu über die Vorlast 18 durch eine entsprechende Ansteuerung durch den Mikrocontroller 20 entladen.

Um die variable Vorlast 18 zur Entladung des Speicherkondensators 16 des Zwischenkreises zu nutzen, ist es vorteilhaft, den DC/DC-Wandler 22 so auszugestalten, dass er bis zu sehr kleinen Spannungen hinab arbeitet. Damit kann der Zwischenkreis bis auf eine ungefährliche Restladung entladen werden. Dabei ist es völlig ausreichend, wenn der DC/DC-Wandler 22 bei kleinen Eingangsspannungen nur einen Teil seiner Nennleistung liefern kann. Damit die Ausgangsspannung des DC/DC-Wandlers 22 dann nicht zusammenbricht, kann die variable Vorlast 18 in ihrer Leistung zurückgefahren oder bei Unterschreitung einer Mindestspannung durch den Mikrocontroller 20 ausgeschaltet werden.

Zur Warnung des Personals kann eine Anzeigevorrichtung (nicht dargestellt) vorgesehen sein, mit welcher der Ladezustand des Speicherkondensators 16 des Zwischenkreises optisch angezeigt werden kann. Dies geschieht zum Beispiel in stromsparender und zugleich gut sichtbarer Weise durch eine periodisch aufblitzende LED, deren Blitzfrequenz proportional zur Ladung im Zwischenkreis ist.

Des Weiteren kann auch eine Anzeigevorrichtung zum Anzeigen eines Entladestroms des Speicherkondensators 16 des Zwischenkreises durch die variable Vorlast 18 vorgesehen sein.

Hinsichtlich der Wirkungsweise und der Einsatzmöglichkeiten der variablen Vorlast 18 wird ergänzend auf die eingangs bereits erwähnte EP 1 970 964 A2 verwiesen, deren diesbezüglicher Inhalt hierdurch auch zum Gegenstand dieser Anmeldung gemacht werden soll.

Unter Bezug auf Fig. 2 wird nun ein zweites Ausführungsbeispiel eines Solarmoduls näher erläutert. Dabei sind gleiche bzw. entsprechende Komponenten mit den gleichen Bezugsziffern gekennzeichnet, und nachfolgend werden nur die Unterschiede zum ersten Ausführungsbeispiel von Fig. 1 beschrieben.

Aufgrund der hohen Spannungen des Solargenerators 10 wird der Zwischenkreis häufig als Reihenschaltung von mehreren Elektrolytkondensatoren 16₁, 16₂ ausgeführt, wie in Fig. 2 dargestellt. In diesem Fall ist jedem der Speicherkondensatoren 16₁, 16₂ des Zwischenkreises ein DC/DC-Wandler 22₁, 22₂ (mit einem Einfach-Eingang) zugeordnet.

Die variable Vorlast 18 ist vorzugsweise an den gemeinsamen Ausgang der beiden DC/DC-Wandler 22₁, 22₂ angeschlossen. Die variable Vorlast 18 dieses und der folgenden Ausführungsbeispiele ist vereinfacht dargestellt. Die im vorherigen Ausführungsbeispiel erläuterten Varianten sind ebenfalls gültig.

Die DC/DC-Wandler 22₁, 22₂ können in diesem Fall auch zu einer Symmetrierung der Speicherkondensatoren 16₁, 16₂ des Zwischenkreises verwendet werden. Zu diesem Zweck werden die DC/DC-Wandler 22₁, 22₂ beispielsweise so geregelt, dass die höher aufgeladenen Zwischenkreiskondensatoren 16₁, 16₂ stärker entladen werden.

Der übrige Aufbau und die Funktionsweise dieses Solarmoduls von Fig. 2 entsprechen jenen des in Fig. 1 dargestellten ersten Ausführungsbeispiels.

Während in Fig. 2 die variable Vorlast 18 an den gemeinsamen Ausgang der DC/DC-Wandler 22₁, 22₂ angeschlossen sind, ist es auch möglich, an die getrennten Ausgänge der DC/DC-Wandler 22₁, 22₂ jeweils eine variable Vorlast 18 anzuschließen.

Bezug nehmend auf Fig. 3 wird nun ein drittes Ausführungsbeispiel eines Solarmoduls näher erläutert. Dabei sind gleiche bzw. entsprechende Komponenten wieder mit den gleichen Bezugsziffern gekennzeichnet, und nachfolgend werden nur die Unterschiede zum zweiten Ausführungsbeispiel von Fig. 2 beschrieben.

Das in Fig. 3 gezeigte Solarmodul unterscheidet sich von dem Solarmodul des zweiten Ausführungsbeispiels von Fig. 2 dadurch, dass die mehreren in Reihe geschalteten Speicherkondensatoren 16₁, 16₂ des Zwischenkreises mit nur einem DC/DC-Wandler 22₃ mit einem Mehrfach-Eingang gekoppelt sind.

DC/DC-Wandler mit einem Mehrfach-Eingang sind bereits grundsätzlich bekannt und sollen daher im Rahmen dieser Anmeldung nicht näher erläutert werden. Nur beispielhaft sei diesbezüglich auf die CN 101 534 058 A und die 101 534 061 A verwiesen.

Der übrige Aufbau und die Funktionsweise dieses Solarmoduls von Fig. 3 entsprechen jenen des in Fig. 2 dargestellten Solarmoduls.

Unter Bezug auf Fig. 4 wird nun ein viertes Ausführungsbeispiel eines Solarmoduls näher erläutert. Dabei sind gleiche bzw. entsprechende Komponenten mit den gleichen Bezugsziffern gekennzeichnet, und nachfolgend werden nur die Unterschiede zum ersten Ausführungsbeispiel von Fig. 1 beschrieben.

Das in Fig. 4 gezeigte Solarmodul unterscheidet sich von dem Solarmodul des ersten Ausführungsbeispiels von Fig. 1 dadurch, dass ein Solargenerator 10 über einen DC/DC-Wandler 32, beispielsweise einen Hochsetzsteller, mit einem Zwischenkreis verbunden ist. Der DC/DC-Wandler 32 ermöglicht eine Anpassung der durch den Solargenerator 10 erzeugten Spannung an die Netzspannung.

Die dargestellten Ausführungsbeispiele können im Zwischenkreis anstelle wenigstens eines Zwischenkreiskondensators 16 wenigstens eine Drossel aufweisen.

Selbstverständlich können das zweite und das dritte Ausführungsbeispiel auch miteinander kombiniert werden, wenn der Zwischenkreis mehr als zwei Speicherkondensatoren umfasst. In diesem Fall kann das Solarmodul mehrere DC/DC-Wandler 22₁, 22₂ mit einem Einfach-Eingang, mehrere DC/DC-Wandler 22₃ mit einem Mehrfach-Eingang oder wenigstens einen DC/DC-Wandler 22₁, 22₂ mit einem Einfach-Eingang und wenigstens einen DC/DC-Wandler 22₃ mit einem Mehrfach-Eingang aufweisen.

Ebenso kann das vierte Ausführungsbeispiel mit dem zweiten oder dem dritten Ausführungsbeispiel kombiniert werden.

## Patentansprüche

1. Solarmodul, mit einem Solargenerator (10) zum Umwandeln einfallender Strahlung in elektrische Leistung; einem mit dem Solargenerator (10) verbundenen Zwischenkreis; einem Solarwechselrichter (12) zum Einspeisen der vom Solargenerator (10) erzeugten Leistung in ein Netz (14) oder einen Verbraucher; einer variablen Vorlast (18), die an den Solargenerator (10) angeschlossen ist; und einer Steuervorrichtung (20) zum Ansteuern der variablen Vorlast (18),
**dadurch gekennzeichnet, dass** der Solargenerator (10) mit wenigstens einem DC/DC-Wandler (22; 22₁, 22₂; 22₃) zur Energieversorgung des Solarwechselrichters (12) verbunden ist und die variable Vorlast (18) an den wenigstens einen DC/DC-Wandler (22; 22₁, 22₂; 22₃) angeschlossen ist.

2. Solarmodul nach Anspruch 1,
**dadurch gekennzeichnet, dass**
der Zwischenkreis zur Energiespeicherung wenigstens einen Zwischenkreiskondensator (16; 16₁, 16₂) oder wenigstens eine Drossel aufweist.

3. Solarmodul nach Anspruch 1 oder 2,
**dadurch gekennzeichnet, dass**
die variable Vorlast (18) eine lineare oder getaktete Stromsenke (30), die bevorzugt einen ein- und ausschaltbaren Widerstand aufweist, und/oder wenigstens ein schaltbarer Verbraucher (24), bevorzugt mit variabel einstellbarer Stromaufnahme, und/oder wenigstens ein steuerbarer Verbraucher (28) ist.

4. Solarmodul nach einem der vorhergehenden Ansprüche,
**dadurch gekennzeichnet, dass**
der wenigstens eine DC/DC-Wandler (22; 22₁, 22₂; 22₃) ein bis hinab zu sehr kleinen Eingangsspannungen arbeitender DC/DC-Wandler ist.

5. Solarmodul nach einem der vorhergehenden Ansprüche,
**dadurch gekennzeichnet, dass**
der wenigstens eine DC/DC-Wandler (22; 22₁, 22₂; 22₃) mehrere Ausgänge zum verteilten Anschließen von Teilelementen der Vorlast (18) aufweist.

6. Solarmodul nach einem der vorhergehenden Ansprüche,
**dadurch gekennzeichnet, dass**
eine Anzeigevorrichtung zum Anzeigen eines Ladungszustandes des Zwischenkreises bzw. eines Zwischenkreiskondensators (16; 16₁, 16₂) vorgesehen ist.

7. Solarmodul nach einem der vorhergehenden Ansprüche,
**dadurch gekennzeichnet, dass**
eine Anzeigevorrichtung zum Anzeigen eines Entladestroms des Zwischenkreises bzw. eines Zwischenkreiskondensators (16; 16₁, 16₂) durch die variable Vorlast (18) vorgesehen ist.

8. Solarmodul nach einem der vorhergehenden Ansprüche,
**dadurch gekennzeichnet, dass**
der Zwischenkreis mehrere Zwischenkreiskondensatoren (16₁, 16₂) enthält und der wenigstens eine DC/DC-Wandler (22₁, 22₂; 22₃) wenigstens einen DC/DC-Wandler (22₃) mit einem Mehrfach-Eingang umfasst, wobei dieser Mehrfach-Eingang mit mehreren Zwischenkreiskondensatoren (16₁, 16₂) gekoppelt ist.

9. Solarmodul nach einem der vorhergehenden Ansprüche,
**dadurch gekennzeichnet, dass**
der Zwischenkreis mehrere Zwischenkreiskondensatoren (16₁, 16₂) enthält und der wenigstens eine DC/DC-Wandler (22₁, 22₂; 22₃) mehrere DC/DC-Wandler umfasst, von denen wenigstens ein DC/DC-Wandler (22₁, 22₂) ein DC/DC-Wandler mit einem Einfach-Eingang ist, wobei dieser Einfach-Eingang mit einem der mehreren Zwischenkreiskondensatoren (16₁, 16₂) gekoppelt ist.

10. Solarmodul nach einem der vorhergehenden Ansprüche,
**dadurch gekennzeichnet, dass**
der Solargenerator (10) mit dem wenigstens einen Zwischenkreis über wenigstens einen weiteren DC/DC-Wandler (32) verbunden ist.

11. Solarmodul nach einem der vorhergehenden Ansprüche,
**dadurch gekennzeichnet, dass**
die Steuervorrichtung (20) ein Mikrocontroller ist.

12. Verfahren zur Reduzierung der Leistungskapazität einer Vorlast eines Solarmoduls nach einem der Ansprüche 1 bis 11,
**dadurch gekennzeichnet, dass**
eine die Vorlast (18) unterstützende Belastung erzeugt wird.

13. Verfahren nach Anspruch 12,
**dadurch gekennzeichnet, dass**
die unterstützende Belastung durch wenigstens einen Verbraucher erzeugt wird, der üblicherweise in einem Solarmodul enthalten ist.

14. Verfahren nach Anspruch 12 oder 13,
**dadurch gekennzeichnet, dass**
die variable Vorlast (18) durch eine leerlaufende Leistungselektronik eines Solarwechselrichters (12) unterstützt wird.

15. Verfahren nach Anspruch 14,
**dadurch gekennzeichnet, dass**
die unterstützende Belastung durch eine Variation der Taktfrequenz der Leistungshalbleiter der leerlaufenden Leistungselektronik variiert wird.

16. Verfahren nach einem der Ansprüche 12 bis 15,
**dadurch gekennzeichnet, dass**
die unterstützende Belastung durch eine Variation der Taktfrequenz der Leistungshalbleiter der leerlaufenden Leistungselektronik und/oder durch eine Variation der Ausgangsfrequenz des Solarwechselrichters (12) und/oder durch eine Variation der Ausgangsspannung des Solarwechselrichters (12) variiert wird.

17. Verfahren nach einem der Ansprüche 12 bis 16,
**dadurch gekennzeichnet, dass**
der Solargenerator (10) weniger stark belastet wird, als es den Leerlaufverlusten des Solarwechselrichters (12) entspricht.
